# EUROPEAN PATENT APPLICATION

(11) **EP 1 772 212 A1**
(43) Date of publication of application: **11.04.2007**
(21) Application number: 05751501.7
(22) Date of filing: 17.06.2005
(51) Int. Cl.: B22F 1/00, B22F 1/02, B23K 35/26, B23K 35/40, C22B 3/00

(54) **COPPER-CONTAINING TIN POWDER AND METHOD FOR PRODUCING THE COPPER-CONTAINING TIN POWDER, AND ELECTROCONDUCTIVE PASTE USING THE COPPER-CONTAINING TIN POWDER**

(30) Priority: 18.06.2004 JP 2004181818
(71) Applicant: Mitsui Mining & Smelting Co., Ltd, Tokyo 141-8584 (JP)
(72) Inventor: SAKAUE, T., c/o Hikoshima Smelting Co., Ltd, Hikoshima, Shimonoseki-shi, Yamaguchi (JP); FURUMOTO, K., c/o Hikoshima Smelting Co., Ltd, Hikoshima, Shimonoseki-shi, Yamaguchi (JP); YOSHIMARU, K., c/o Hikoshima Smelting Co., Ltd, Hikoshima, Shimonoseki-shi, Yamaguchi (JP)
(74) Representative: Bohmann, Armin K.
(86) International application number: PCT/JP2005/011157
(87) International publication number: WO 2005/123308

(57) **Abstract**

It is an object to provide a copper-containing tin powder having excellent capabilities in forming fine wiring circuits and filling via holes with ability in bond by melting at a lowtemperature. In order to achieve the object, itisproduced from a copper powder as a starting material by a wet substitution process and it contains remainder of copper un-substituted at 30% by weight or less. The change rate of properties of the copper-containing tin powder, e.g. an average primary particle size or the like is in the range from -20 to +5% with respect to the starting copper powders. The copper-containing tin powder is produced by a wet substitution process in which a copper powder is brought into contact with a plating solution for tin substitution to make copper component constituting the copper powder dissolve with simultaneous substituted deposition of tin.

## Description

### Technical Field

The present invention relates to a copper-containing tin powder, a method for producing the copper-containing tin powder and an electro-conductive paste using the copper-containing tinpowder. Inparticular, the maj or objectives of the present invention are to provide a copper-containing tin powder applicable in the same usage with solder powders and are constituted from fine particles which have not been achieved in conventional solder powders, and to provide an electro-conductive paste using the copper-containing tin powder.

### Background Art

Solder powders as disclosed in Patent Document 1 have been widely used for filling via holes in multilayer printed wiring boards, and for powder component in electro-conductive adhesives used for positioning of IC devices or the like when they are mounted on printed wiring boards.

Such solder powders are generally constituted from so-called lead-free solder materials. A conventional solder material has been eutectic solder with 63% by weight of tin and 37% by weight of lead. However, problem in lead is announced of serious environmental loads in causing pollution of water, which may happen after putting into the discard of the consumer use electronic products as represented by cathode-ray tube in TV set and other electronic devices in which lead is used. As a result, using lead-free solders have been major measure to reduce total quantities of lead in such consumer use electronic products.

The solder powders or tin powders have been produced by atomize process, as disclosed in Patent Document 2. Advantage of solder powders produced by atomize process is that the powder is more dispersible than powders produced by a wet process.

Patent Document 1: Japanese Patent Laid-Open No. H10-058190
Patent Document 2: Japanese Patent Laid-Open No. 2000-15482

### Disclosure of the Invention

However, it is known that a solder powder or tin powder (hereinafter referred to as a solder powder or the like) produced by atomize process has a very broad particle size distribution. And it is general that minimum particle size distributing may be in the range from 1 to 10 µm after screening a particle, and it have been clear that it is difficult to get fine particles having an average particle size of 5 µm or less without containing coarse particles when determined by direct measurement from an electron microscope observation. The solder powder or the like with a broad particle size distribution with average particle size of over 5 µm involve the following problems.

First, an electro-conductive paste using a solder powder or the like with broad particle size distribution with average particle size of over 5 µm has drawbacks as following, no capability in forming fine circuits and in filling small via holes. On the other hand, copper powders supplied for the similar applications have an average particle size of 5 µm or less, or 1 µm or less in some cases recently. Under such situations, the solder powders or the like produced by atomize process cannot compete with these fine powders absolutely.

Second, when solder powders or the like produced by atomize process is used for filling via holes in multilayer printed wiring boards, it may melt in the via holes at a flow or reflow temperature during the flow or reflow processing for mounting of devices to cause deformation of the shapes with shrinkage in the via holes. Increasing of coarse particles contained in solder powder or the like filled in the via holes may makes it tends to melt at higher temperature, and show bigger dimensional changes by shrinkage, then reliability of connection within the via holes and an outer layer circuit may lost. The similar problems may be observed when a solder powder or the like produced by atomize process is used in mixture with copper powder or the like.

Under such situations, there have been demands for fine solder powders or tin powders applicable in the fields where solder powders or the like produced by atomize process are used, and which is good for filling small via holes in fine wiring circuits and can secure lower processing temperature.

Consequently, the inventors of the present invention have developed the copper-containing tin powder and the method for producing the same, as described below. Then "copper-containing tin powder", "method for producing the copper-containing tin powder" and "electro-conductive paste using the copper-containing tin powder" will be described in this order.

### <Copper-containing tin powder of the present invention>

The first characteristic of the copper-containing tin powder of the present invention is that the copper-containing tin powder is produced by a wet substitution process from a copper powder as a starting material, and copper content is 30% by weight or less as remainder of substitution. The reason why copper-containing tin powder is developed is that it contains no lead and has properties similar to those of solder or tin powders.

For the copper-containing tin powder of the present invention, in technical common sense, it is difficult to completely substitute the copper component in the copper powder as a starting material with tin because a copper powder as a starting material is changed into a copper-containing tin powder by a wet substitution process. However, most of the copper component should be substituted by the tin component because it is named a copper-containing tin powder. But the substitution speed might greatly decreases after copper particle surfaces are substituted by tin, and the copper component may remain in the particle core. Empirically judging from the studies made by the inventors of the present invention, the copper content can be reduced to 30% by weight or less, although copper cannot be completely substituted. Although the lowest copper content is not defined in this specification, the minimum content of copper remainder after substitution may be around 0.5% by weight, based on the investigation results.

In this specification, a content of the copper component remaining in the copper-containing tin powder was examined as follows: 1 g of the copper-containing tin powder was fully dissolved in a nitric acid solution. Then the copper component in the solution was analyzed by ion plasma emission spectrometry (ICP) or the like as a copper content per 1 g of the copper-containing tin powder. After that, the value obtained is converted into a content of the copper component remaining in the copper-containing tin powder by using a calibration curve.

The second characteristic of the copper-containing tin powder of the present invention is that almost spherical copper-containing tin powders can be produced when the copper particles in the starting material are almost spherical, and flat particles can be produced when the starting copper particles are flat. In other words, such fine copper-containing tin powder which have never been can be produced when a copper powder as a starting material has an average primary particle size smaller than that of a solder powder or the like produced by atomize process.

For example, the copper-containing tin powder may be constituted from almost spherical particles having a sharp particle size distribution with average primary particle size of 5 µm or less, when it is produced from almost spherical copper powder having an average primary particle size of 5 µm or less as a starting material by the wet substitution process described later. It might be a product excellent in forming fine circuits and filling small via holes to an extent that it is considered impossible by using a conventional product. Such a fine copper-containing tin powder cannot be produced by atomize process, and fine particle size allows the powder to show improved processing capability at a low temperature.

An average primary particle size of 5 µm or less in this specification comes from current market demands, and the range has not been achieved in a conventional atomize process. So, minimum value may not necessary to be limited. However, when average primary particle size of the almost spherical or flat particle drops to 5 µm or less, preferably 3 µm or less, capability of filling small via holes having diameter of around 50 µm or less may drastically improved, and it may greatly improve resistance to thermal shrinkage properties. When it is forced to limit the lowest size, viscosity of an electro-conductive paste in which the particles are used should be considered. The electro-conductive paste may show a higher viscosity with smaller size of the particles used and tends to be more difficult to handle. Particles having an average primary particle size of 0.1 µm or less may greatly increase viscosity of the electro-conductive paste in which they are used and viscosity may change with time passing, so handling of the electro-conductive paste and management might be complicated. So, more preferably, the average primary particle size is in a range from 0.1 to 3 µm.

In addition, the copper-containing tin powders obtained have a smaller average particle size than a copper powder used as a starting material. In other words, the copper-containing tin powder produced from a copper powder by a wet substitution process has an average primaryparticle size not much different from or smaller than that of the copper powder as a starting material. The inventors of the present invention have compared the powder properties (average primary particle size, or aspect ratio for flat particles) within copper-containing tin powder produced by using the producing method described later and the copper powder as a starting material. It is found that the change rate of properties is in the range from -20 to +5%. Change rate is defined by the formula ([value of the copper-containing tin powder after substitution]-[value of the copper powder before substitution]/ [value of the copper- powder before substitution] ×100(%).

Table 1 shows one example of the change rate of fine copper-containing tin powder having an almost spherical particle shape. The almost spherical powder shown in Table 1 is the best result produced by the substitution process similar to that in EXAMPLE 1 described later, from a copper powder as a starting material which has an average primary particle size of 2.16 µm (average of the particle size in a view obtained by SEM (Scanning Electron Microscope) observation) with sharp size distribution. As shown in Table 1, change of the powder properties is slight between before and after of the substitution. The D₅₀ value which is described in this specification for reference is a volumetric cumulative particle size, determined by a laser diffraction/scattering particle size distribution analyzer (Micro Trac HRA 9320 -X100, product of Leeds & Northrup Co.).

**[Table 1]**

| | | Almost spherical powder | | |
|---|---|---|---|---|
| Items | Unit | Copper powder before substitution | Copper-containing tin powder after substitution | Change rate (%) |
| Average primary particle size | µm | 2.16 | 2.15 | - 0.5 |
| D₅₀ | | 2.18 | 2.17 | - |

The copper-containing tin powder, produced by the wet substitution process described later from flat, flaky copper powder as a starting material having an average primary particle size of 5 µm or less, is finished as flat particles having an average primary particle size of 5 µm or less which cannot be produced before. Such copper-containing tin powder of fine, flat particles cannot be produced by an atomize process, and the finer particle size may improve ability in bond by melting at low temperature and space filling rate. Also in the flat copper-containing tin powders, when average primary particle size drops to 5 µm or less, preferably 3 µm or less, capability of filling small via holes having diameter of around 50 µm or less may drastically improved, and it may greatly improve resistance to thermal shrinkage properties. The copper-containing tin powder preferably hasan average primary particle size in a range from 0.1 to 3 µm as is same with the case using the spherical particles, in consideration of viscosity of an electro-conductive paste.

Table 2 shows an example of another copper-containing tin powder having a flaky particle shape. The flaky powder shown in Table 2 is the best result produced by the substitution process similar to that in EXAMPLE 1 described later, from a copper powder as a starting material having an average primary particle size of 0.62 µm (average of the particle size for longer direction in a view of SEM observation), an aspect ratio (average primary particle size/average thickness) of 7 with sharp size distribution. As shown in Table 2, change of the powder properties is slight between before and after of the substitution.

**[Table 2]**

| | | Flaky powder | | |
|---|---|---|---|---|
| Items | Unit | Copper powder before substitution | Copper-containing tin powder after substitution | Change rate (%) |
| Average primary particle size | µm | 0.62 | 0.64 | +3.2 |
| D₅₀ | | 0.75 | 0.71 | - |
| Aspect ratio | - | 7.0 | 6.9 | -1.8 |

### <Method for producing the copper-containing tin powder of the present invention>

The method of the present invention for producing the copper-containing tin powder is characterized in that a wet substitution process in which a copper powder is brought into contact with a plating solution for tin substitution to make copper component constituting the copper powder dissolve with simultaneous substituted deposition of tin. The plating solution for tin substitution is preferred to be aqueous solution containing stannous chloride, thiourea and an acid solution.

### <Copper powder mixture containing the copper-containing tin powder of the present invention>

The copper-containing tin powder of the present invention contains a tin component which has low melting point at 70% or more. Therefore, using an electro-conductive paste produced by using only the copper-containing tin powder of the present invention may cause voids in the process for removing a solvent from the paste after forming a conductor, e. g. , via hole, even capability in hole filling in the via-hole is improved. As a result, it is natural to cause dimensional changes of the conductor after the copper-containing tin powders melt and bond together. In other words, good performance in dimensional stability as a conductor is naturally limited.

So, to minimize dimensional changes of the basic conductor structure in a via hole even if deformation due to melting of the copper-containing tin powder may occur during heating, dimensional stability of the conductor shape can be easily secured by preparing a paste with additional powder of higher melting point, e.g., copper or silver, when compared with a case where a paste contains only tin powder of low melting point.

A mixing ratio of the copper-containing tin powder of the present invention to another powder, e.g. , copper, is not limited. Factors to be considered when the ratio should be set are usage of the powder mixture and a combination of particle size distribution of the copper-containing tin powder and another powder. However, the powder mixture preferably contains the copper-containing tin powder of the present invention in the range from 1 to 50% by weight, based on the extensive studies made by the inventors. At lower than 1% by weight, the copper-containing tin powders may melt but fail to stably connect particles of another kinds of powders each other with sufficient mechanical strength when an electro-conductive paste in which the powder mixture is used to form a conductor, e.g., via hole. At higher than 50% by weight, on the other hand, dimensional stability of the conductor, e.g. via hole, formed with the electro-conductive paste after heating, e.g., in the reflow process, dimensional stability of the conductor may rapidly start to deteriorate

### <Electro-conductive paste using the copper-containing tin powder of the present invention>

The metallic powders such as the copper-containing tin powder of the present invention or the above-described powder mixture are blended into an organic agent to produce an electro-conductive paste. And they are used for forming electrodes of chip devices, forming circuits on printed wiring boards, forming via holes and so forth. The fine particles of copper-containing tin powder of the present invention can perform conductors of high precision in thickness, width, edge linearity and so forth, which has not been achieved with a conventional tin powder or solder powder.

### [Advantages of the Invention]

The copper-containing tin powder of the present invention is produced by the wet substitution process from a copper powder as a starting material. The copper-containing tin powder produced by this process characteristically contains the remainder of copper component un-substituted. The method for producing the copper-containing tin powder of the present invention gives the product whose powder properties are not much different from those of the copper powder as a starting material. Therefore, by using a fine copper powder of almost spherical shape or flat shape, e.g., flaky powder, the copper-containing tin powder much finer than a solder or tin powder produced by a conventional atomize process can be produced.

Moreover, the copper-containing tin powder of the present invention can be efficiently produced by the a wet substitution process in which a copper powder is brought into contact with a plating solution for tin substitution to make copper component constituting the copper powder dissolve with simultaneous substituted deposition of tin.
Figure 1 presents the almost spherical copper powders before substitution observed by SEM;
Figure 2 presents the copper-containing tin powders prepared by the substitution process observed by SEM;
Figure 3 presents the almost spherical copper powders before substitution observed by SEM;
Figure 4 presents the copper-containing tin powders prepared by the substitution process observed by SEM;
Figure 5 presents the almost spherical copper powders before substitution observed by SEM;
Figure 6 presents the copper-containing tin powders prepared by the substitution process observed by SEM;
Figure 7 presents the copper-containing tin powders prepared by the substitution process observed by SEM;
Figure 8 presents the flaky copper powders before substitution observed by SEM;
Figure 9 presents the flaky copper-containing tin powders prepared by the substitution process observed by SEM;
Figure 10 presents the copper-containing tin powders prepared by the substitution process observed by SEM;
Figure 11 presents the tin powders prepared by atomize process observed by SEM; and
Figure 12 presents the tin powders prepared by atomize process observed by SEM.

### Best Mode for Carrying Out the Invention

The embodiments for producing the copper-containing tin powder of the present invention are described below and explain the present invention in more detail by showing EXAMPLES and COMPARATIVE EXAMPLES.

### <Embodiments for producing the copper-containing tin powder of the present invention>

The method of the present invention for producing the copper-containing tin powder adopt a wet substitution process in which a copper powder is brought into contact with a plating solution for tin substitution to make copper component constituting the copper powder dissolve with simultaneous substituted deposition of tin. The plating solution for tin substitution is preferred to be aqueous solution containing stannous chloride, thiourea and an acid solution.

In particular, the acid solution is preferably selected from tartaric acid, ascorbic acid or hydrochloric acid solution. When tartaric acid is selected as the acid solution for the plating solution for tin substitution, the aqueous solution for tin substitution preferably contain stannous chloride at 1 to 200 g/L, thiourea at 10 to 500 g/L and tartaric acid at 10 to 400 g/L. The plating solution for tin substitution of this composition makes it possible to cause the rapid substitution reaction without big change from the powder properties of the starting copper powder.

With a stannous chloride concentration at lower than 1 g/L, substitution speed of copper by tin goes down and plenty of solution is required, so it may fail to satisfy industrially required productivity. With a stannous chloride concentration at higher than 200 g/L, it does not improve substitution efficiency of copper by tin. But it may roughen the copper-containing tin powder surfaces, and may cause increase of viscosity of an electro-conductive paste in which the particles are used.

Thiourea is a complexing agent for the tin deposition by substitution with copper, and also exhibits smoothening effect on a particle surface. And at the same time, it works as promoter for dissolving copper. With a thiourea concentration at lower than 10 g/L, the resulting copper-containing tin powder surfaces may not be sufficiently smoothened to cause increase of viscosity of an electro-conductive paste in which the particles are used. With a thiourea concentration at higher than 500 g/L, it may not further smoothen the resulting copper-containing tin powder surfaces, only to consume resources wastefully.

Tartaric acid works as an oxidation agent to promote dissolving of copper powders. It is a major agent for accelerating the substitution reaction by oxidizing the copper particle surfaces for rapid dissolving. With a tartaric acid concentration at lower than 10 g/L, the copper particle surfaces may not dissolve rapidly and fail to accelerate the substitution reaction itself. With a tartaric acid concentration at higher than 400 g/L, it may not able to balance a dissolving speed of copper particles with a tin deposition speed in consideration of the stannous chloride concentration. So it may fail to accelerate the substitution reaction without big change from the copper powder properties as a starting material.

When ascorbic acid is selected as the acid solution for the plating solution for tin substitution, the aqueous solution preferably contain stannous chloride at 1 to 200 g/L, thiourea at 10 to 500 g/L and ascorbic acid at 10 to 300 g/L. The solution for tin substitution of this composition makes it possible to cause the rapid substitution reaction without big change from the powder properties of the starting copper powder.

The reason for setting stannous chloride concentration range is as same as that for the solution containing tartaric acid.

Thiourea is a complexing agent for the tin deposition by substitution with copper, and also exhibits smoothening effect on a particle surface, as same with the case when the solution contains tartaric acid as an acid solution. But in the case when ascorbic acid is selected, thiourea concentration can be reduced from that with tartaric acid. With a thiourea concentration at lower than 5 g/L, substitution speed of copper by tin goes down, so it may fail to satisfy industrially required productivity. And also it results copper-containing tin powder surfaces not be sufficiently smoothened to cause increase of viscosity of an electro-conductive paste in which the particles are used. With the concentration at higher than 300 g/L, it may not further smoothen surface of the copper-containing tin powder obtained after deposition by substitution, only to consume resources wastefully.

Ascorbic acid works as an oxidation agent to promote dissolving of copper particles by interactions with thiourea. It is a major agent for accelerating the substitution reaction by oxidizing the copper particle surfaces for rapid dissolving. With an ascorbic acid concentration at lower than 10 g/L, the copper particle surfaces may not dissolve rapidly and fail to accelerate the substitution reaction itself. With an ascorbic acid concentration at higher than 300 g/L, it may not able to balance a dissolving speed of copper particles with a tin deposition speed in consideration of the stannous chloride concentration. So it may fail to accelerate the substitution reaction without big change from the copper powder properties as a starting material.

In order to cause the substitution reaction by using one of the above-described solutions, it is preferable to keep the solution temperature at 30 to 90°C with sufficient stirring. At lower than 30°C, the reaction to substitute copper by tin will proceed at an insufficient speed and needs a longer reaction time and it may fail to satisfy industrially required productivity. At higher than 90°C, on the other hand, the substitution reaction will proceed at an excessively high speed, and tendency may appear to show difference from the starting copper powder properties and reduce service life of the solution.

The preferable method for contacting a starting copper powder with a plating solution for tin substitution is that the copper powder is dispersed in the aqueous solution to prepared slurry, followed by addition of the plating solution for tin substitution into the slurry. The adding method of plating solution for tin substitution can be selected from addition all at once or slow addition in constant speed. However, it is recommended to add slowly by taking 10 minutes or more, preferably 1 hour or more, in order to keep the starting copper powder properties unchanged as far as possible.

### [EXAMPLE 1]

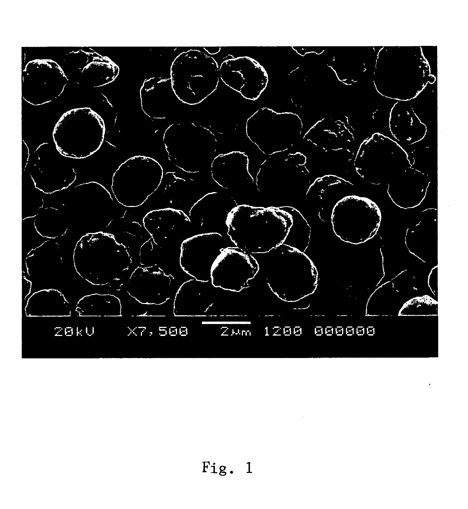

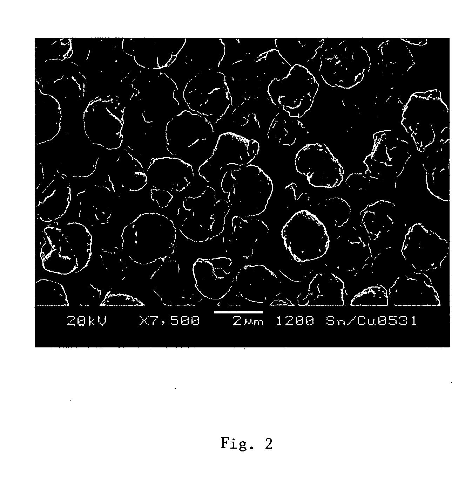

In EXAMPLE 1, the substitution reaction was carried out under the following conditions in which rapid substitution reaction can occur without big change from the starting copper powderproperties. First, 50 g of a copperpowderwas dispersed into 10 L of pure water to prepare the copper powder slurry and kept at 40°C, to which 5L of a plating solution for tin substitution was added in a given time to prepare the copper-containing tin powder of the present invention. The plating solution for tin substitution was an aqueous solution containing stannous chloride at 16.0 g/L, thiourea at 146.4 g/L and tartaric acid at 103.6 g/L, and kept at 40°C. The starting powder in this Example is constituted from almost spherical copper powders shown in Table 3 and Figure 1, and adopted the above-described substitution procedure in which the plating solution for tin substitution was added slowly by taking for 10 minutes, to produce the copper-containing tin powder of the present invention (Figure 2). The copper-containing tin powder obtained in EXAMPLE 1 contains the remainder of copper at 15.2% by weight.

**[Table 3]**

| | | Almost spherical powder | | |
|---|---|---|---|---|
| Items | Unit | Copper powder before substitution | Copper-containing tin powder after substitution | Change rate (%) |
| Average primary particle size | µm | 2.12 | 2.03 | - 4.2 |
| D₅₀ | | 2.15 | 2.15 | - |

As shown in Table 3, it is understood that the resulting copper-containing tin powder is constituted from the fine particles having a primary particle size of 2.03 µm and has the powder properties not much different from those of the starting copper powder. This is also obvious from comparison within Figure 1 and Figure 2.

### [EXAMPLE 2]

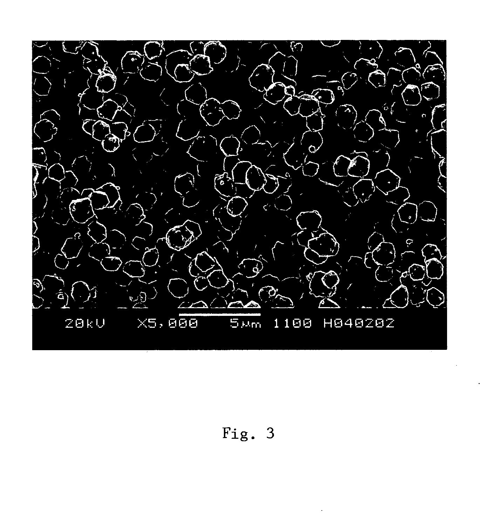

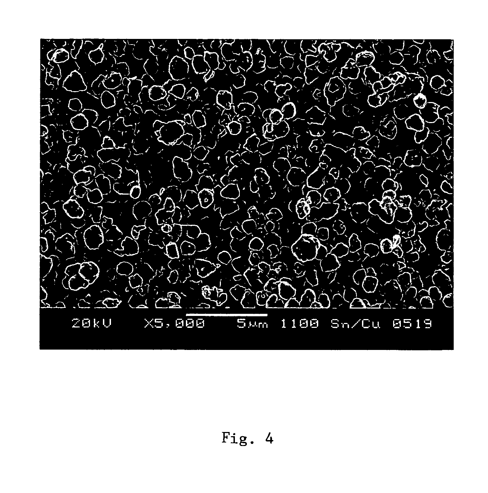

In EXAMPLE 2, the substitution reaction was carried out in a manner similar to that in EXAMPLE 1 under the following conditions in which rapid substitution reaction can occur without big change from the starting copper powder properties. The starting powder in this Example is constituted from almost spherical copper powders shown in Table 4 and Figure 3, and adopted the above-described substitution procedure in which the plating solution for tin substitution was added slowly by taking for 2 hours, to produce the copper-containing tin powder of the present invention (Figure 4). The copper-containing tin powder obtained in EXAMPLE 2 contains the remainder of copper at 5.0% by weight.

**[Table 4]**

| | | Almost spherical powder | | |
|---|---|---|---|---|
| Items | Unit | Copper powder before substitution | Copper-containing tin powder after substitution | Change rate (%) |
| Average primary particle size | µm | 1.32 | 1.17 | -11.4 |
| D₅₀ | | 1.34 | 1.31 | - |

As shown in Table 4, it is understood that the resulting copper-containing tin powder is constituted from the fine particles having a primary particle size of 1.17 µm and has the powder properties not much different from those of the starting copper powder. This is also obvious from comparison within Figure 3 and Figure 4.

### [EXAMPLE 3]

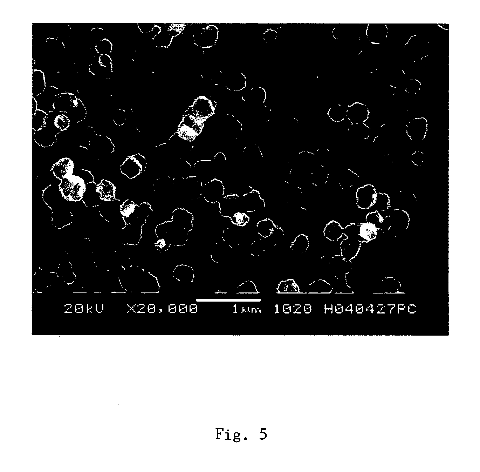

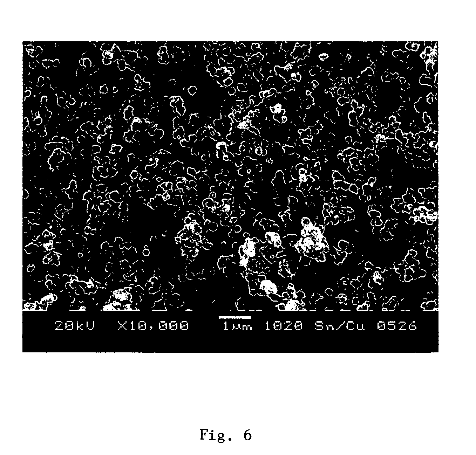

In EXAMPLE 3, the substitution reaction was carried out in a manner similar to that in EXAMPLE 1 under the following conditions in which rapid substitution reaction can occur without big change from the starting copper powder properties. The starting powder in this Example is constituted from almost spherical copper powders shown in Table 5 and Figure 5, and adopted the above-described substitution procedure in which the plating solution for tin substitution was added slowly by taking for 2 hours, to produce the copper-containing tin powder of the present invention (Figure 6). The copper-containing tin powder obtained in EXAMPLE 3 contains the remainder of copper at 3.1% by weight.

**[Table 5]**

| | | Almost spherical powder | | |
|---|---|---|---|---|
| Items | Unit | Copper powder before substitution | Copper-containing tin powder after substitution | Change rate (%) |
| Average primary particle size | µm | 0.32 | 0.27 | - 15.6 |
| D₅₀ | | 0.41 | 0.59 | - |

As shown in Table 5, it is understood that the resulting copper-containing tin powder is constituted from the fine particles having a primary particle size of 0.27 µm and has the powder properties not much different from those of the starting copper powder. This is also obvious from comparison within Figure 5 and Figure 6. [EXAMPLE 4]

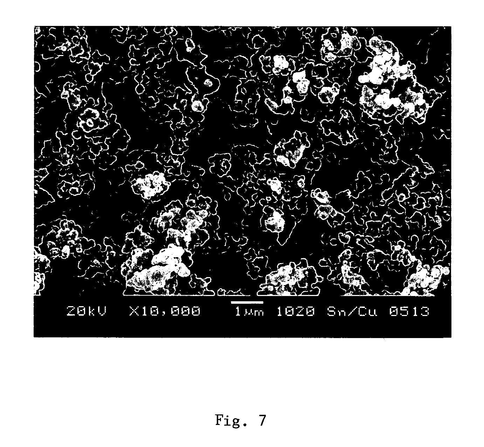

In EXAMPLE 4, the substitution reaction was carried out in a manner similar to that in EXAMPLE 1 under the following conditions in which rapid substitution reaction can occur without big change from the starting copper powder properties. The starting powder in this Example is constituted from almost spherical copper powders shown in Table 6 and Figure 5, and adopted the above-described substitution procedure in which the plating solution for tin substitution was added in bulk, to produce the copper-containing tin powder of the present invention (Figure 7). The copper-containing tin powder obtained in EXAMPLE 4 contains the remainder of copper at 26.9% by weight.

**[Table 6]**

| | | Almost spherical powder | | |
|---|---|---|---|---|
| Items | Unit | Copper powder before substitution | Copper-containing tin powder after substitution | Change rate (%) |
| Average primary particle size | µm | 0.32 | 0.30 | - 6.2 |
| D₅₀ | | 0.41 | 0.85 | - |

As shown in Table 6, it is understood that the resulting copper-containing tin powder is constituted from the fine particles having a primary particle size of 0.30 µm and has the powder properties not much different from those of the starting copper powder. This is also obvious from comparison within Figure 5 and Figure 7. [EXAMPLE 5]

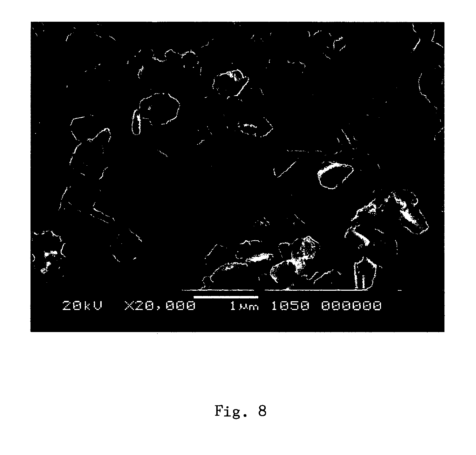

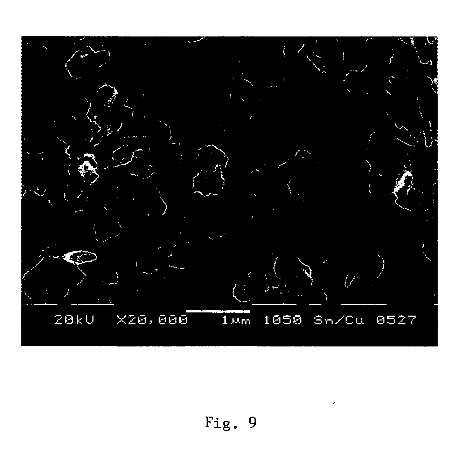

In EXAMPLE 5, the substitution reaction was carried out in a manner similar to that in EXAMPLE 1 under the following conditions in which rapid substitution reaction can occur without big change from the starting copper powder properties. The starting powder in this Example is constituted from flaky copper powders shown in Table 7 and Figure 8, and adopted the above-described substitution procedure in which the plating solution for tin substitution was added slowly by taking for 2 hours, to produce the copper-containing tin powder of the present invention (Figure 9). The copper-containing tin powder obtained in EXAMPLE 1 contains the remainder of copper at 17.7% by weight.

**[Table 7]**

| | | Flaky powder | | |
|---|---|---|---|---|
| Items | Unit | Copper powder before substitution | Copper-containing tin powder after substitution | Change rate (%) |
| Average primary particle size | µm Am | 0.62 | 0.53 | - 14.5 |
| D₅₀ | | 0.67 | 0.90 | - |
| Aspect ratio | - | 6.8 | 7.1 | + 4.1 |

As shown in Table 7, it is understood that the resulting copper-containing tin powder is constituted from the fine particles having a primary particle size of 0.53 µm and has the powder properties not much different from those of the starting flaky copper powder. This is also obvious from comparison within Figure 8 and Figure 9.

### [EXAMPLE 6]

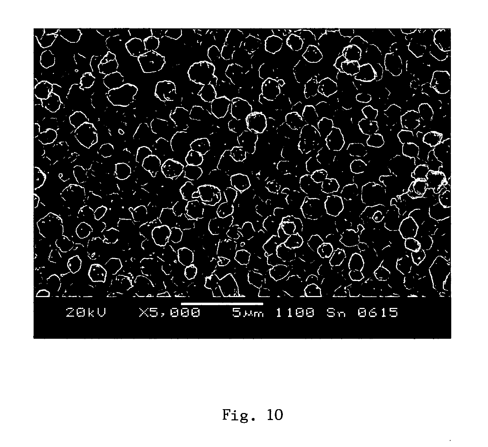

In EXAMPLE 6, the substitution reaction was carried out under the following conditions in which rapid substitution reaction can occur without big change from the starting copper powderproperties. First, 25g of a copper powder was dispersed into 2 L of pure water to prepare the copper powder slurry and kept at 50°C, to which 3 L of a plating solution for tin substitution was added in a given time to prepare the copper-containing tin powder of the present invention. The plating solution for tin substitution was an aqueous solution containing stannous chloride at 27.0 g/L, thiourea at 43.3 g/L and ascorbic acid at 43.3 3 g/L and kept at 50°C . The starting powder in this Example is constituted from almost spherical copper powders shown in Table 8 and Figure 3, and adopted the above-described substitution procedure in which the plating solution for tin substitution was added slowly by taking for 5 minutes, to produce the copper-containing tin powder of the present invention (Figure 10). The copper-containing tin powder obtained in EXAMPLE 1 contains the remainder of copper at 24.5% by weight.

**[Table 8]**

| | | Almost spherical powder | | |
|---|---|---|---|---|
| Items | Unit | Copper powder before substitution | Copper-containing tin powder after substitution | Change rate (%) |
| Average primary particle size | µm | 1.32 | 1.14 | - 13.6 |
| D₅₀ | | 1.34 | 1.21 | - |

As shown in Table 8, it is understood that the resulting copper-containing tin powder is constituted from the fine particles having a primary particle size of 1.14 µm and has the primary particle size not much different from those of the starting copper powder. This is also obvious from comparison within Figure 3 and Figure 10.

### [COMPARATIVE EXAMPLE]

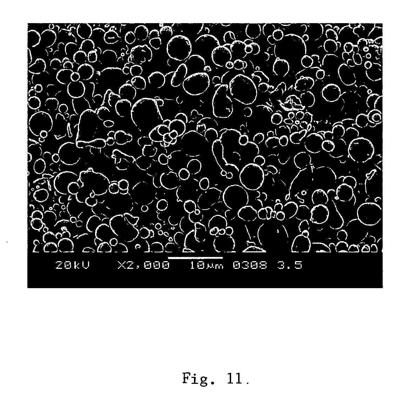

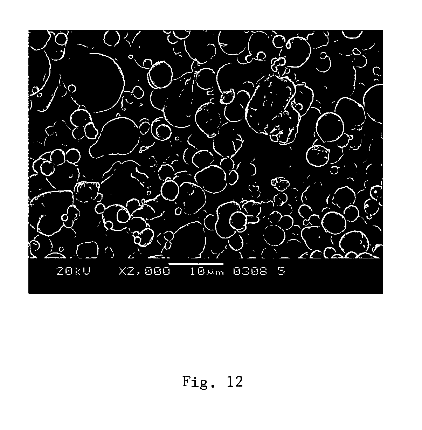

The COMPARATIVE EXAMPLE shows two types of tin powders prepared by atomize process in Figures 11 and 12. As clear from those photographs obtained by SEM observation, these powders produced by atomi z e process have wide ly varying primary particle sizes, so it is not useful to determine average primary particle sizes by directly observing particle shapes in a SEM observation.

It is obvious, when these SEM observations in Figures 11 and 12 are compared with those observed in each of EXAMPLES, the copper-containing tin powders prepared in EXAMPLES has more even particle size although finer.

### Industrial Applicability

The copper-containing tin powder of the present invention is produced from a copper powder as a starting material by a wet substitution process, which gives the finished powder having powder properties not much different from those of the starting powder. Therefore, it makes it possible to prepare an electro-conductive paste for production of fine circuits by using copper-containing tin powder produced from almost spherical copper powder and flat, flaky copper powder which have powder properties similar to those of copper powder having fine particles useful for fine circuit formation.

From the production technology viewpoint, the wet substitution process can use a copper powder as a starting material, for which most stable production management have been established for fine powder production, so the copper-containing tin powder finer than a powder produced by atomize process can be supplied to the markets.

## Claims

1. A copper-containing tin powder produced from a copper powder as a starting material by a wet substitution process, **characterized in that** the copper-containing tin powder contains remainder of copper un-substituted at 30% by weight or less.

2. The copper-containing tin powder according to Claim 1 produced from a copper powder as a starting material by a wet substitution process, **characterized in that** the copper-containing tin powder is constituted from almost spherical particles having an average primary particle size of 5 µm or less.

3. The copper-containing tin powder according to Claim 1 produced from a copper powder as a starting material by a wet substitution process, **characterized in that** the copper-containing tin powder is constituted from flaky particles having an average primary particle size of 5 µm or less.

4. The copper-containing tin powder according to Claim 3, **characterized in that** the copper-containing tin powder is constituted from particles with flat shape having an average aspect ratio of 1 to 20.

5. The copper-containing tin powder according to any of Claims 1 to 4 produced from a copper powder as a starting material by a wet substitution process, **characterized in that** the change rates of an average primary particle size and an aspect ratio for the flat particles of the copper-containing tin powder are in the range from -20 to +5% with respect to those of the copper powder as a starting material.

6. A method for producing the copper-containing tin powder according to any of Claims 1 to 5, **characterized in that**
a wet substitution process is adopted in which a copper powder is brought into contact with a plating solution for tin substitution to make copper component constituting the copper powder dissolve with simultaneous substituted deposition of tin.

7. The method according to Claim 6 for producing the copper-containing tin powder, **characterized in that** the plating solution for tin substitution is an aqueous solution containing stannous chloride, thiourea and an acid solution.

8. A powder mixture prepared by mixing the copper-containing tin powder according to any of Claims 1 to 5 with another powder.

9. An electro-conductive paste using the copper-containing tin powder according to any of Claims 1 to 5.

10. An electro-conductive paste using the powder mixture according to Claim 8.
